# EUROPEAN PATENT SPECIFICATION

(11) **EP 1 337 377 B1**
(45) Date of publication and mention of the grant of the patent: **27.04.2005**
(21) Application number: 01970116.8
(22) Date of filing: 17.09.2001
(51) Int. Cl.: B23K 35/26, B23K 101/36

(54) **SOLDER MATERIAL AND ELECTRIC OR ELECTRONIC DEVICE IN WHICH THE SAME IS USED**
WEICHLOTWERKSTOFF UND DESSEN VERWENDUNG IN EIN ELEKTRISCHES ODER ELEKTRONISCHES BAUTEIL
MATERIAU DE BRASAGE ET DISPOSITIF ELECTRIQUE OU ELECTRONIQUE UTILISANT CE MATERIAU

(30) Priority: 18.09.2000 JP 2000281718
(43) Date of publication of application: 27.08.2003
(73) Proprietor: MATSUSHITA ELECTRIC INDUSTRIAL CO., LTD., Kadoma-shi, Osaka 571-8501 (JP)
(72) Inventor: YAMAGUCHI, Atsushi, Minoo-shi, Osaka 562-0044 (JP); HIRANO, Masato, Toyonaka-shi, Osaka 560-0055 (JP); SAKAI, Yoshinori, Sasayama-shi, Hyogo 669-2102 (JP)
(74) Representative: Eisenführ, Speiser & Partner
(86) International application number: PCT/JP2001/008030
(87) International publication number: WO 2002/022302

(56) References cited:
- EP-A- 0 847 829
- EP-A- 0 855 242
- DE-A- 10 003 665
- PATENT ABSTRACTS OF JAPAN vol. 1998, no. 06, 30 April 1998 (1998-04-30) & JP 10 034376 A (NIPPON GENMA:KK), 10 February 1998 (1998-02-10)
- PATENT ABSTRACTS OF JAPAN vol. 1997, no. 11, 28 November 1997 (1997-11-28) & JP 09 174279 A (SENJU METAL IND CO LTD;MATSUSHITA ELECTRIC IND CO LTD), 8 July 1997 (1997-07-08)
- PATENT ABSTRACTS OF JAPAN vol. 2000, no. 04, 31 August 2000 (2000-08-31) & JP 2000 015476 A (ISHIKAWA KINZOKU KK), 18 January 2000 (2000-01-18)

## Description

### Technical Field

The present invention relates to a solder material for connecting an external electrode of an electronic component to a land formed on a board (or a substrate) so as to mount the electronic component on the board in a process of manufacturing an electronic circuit board. Further, the present invention relates to a connection structure utilizing such solder material and an electronic or electric apparatus in which such solder material is used for connection.

### Background Art

In recent years, a demand for a portable electronic device such as a mobile phone, a digital camera or the like has been increased, and downsizing and improvement for a higher performance of such an electronic device has been made progressively. Concurrently, it has been strongly desired to increase a reliability of an electronic circuit board which is contained in the electronic device. Therefore, there is a demand to increase a mechanical strength and a heat resistive fatigue strength with respect to a solder material which is used in a mounting process of the electronic components.

Moreover, while a concern about the protection of the global environment is increased in a worldwide scale, a regulation or a law system to control industrial waste treatments is being arranged. As to the electronic circuit board incorporated in the electronic device, lead contained in a solder material for connecting the electronic component to the board may cause an environmental pollution if it is subjected to an inadequate waste treatment, so that researches and developments are carried out as to a solder material which does not contain lead (i.e. a so-called lead-free solder material) as an alternative of the solder material containing lead.

A solder material which has been generally used hitherto is an Sn-Pb based solder material which contains Sn and Pb as main constituents (or components). An eutectic composition of an Sn-Pb alloy is 63Sn-37Pb (namely, a composition of 63 % by weight of Sn and 37 % by weight of Pb on the basis on the whole), and the Sn-Pb alloy has the lowest melting point of 183 °C at the eutectic composition. Because of such lowest melting point, the Sn-Pb based alloy having the eutectic composition is generally used as the solder material. Hereinafter, such Sn-Pb based alloy having the eutectic composition is also referred to as an "Sn-Pb eutectic alloy material" or an "Sn-Pb eutectic solder material".

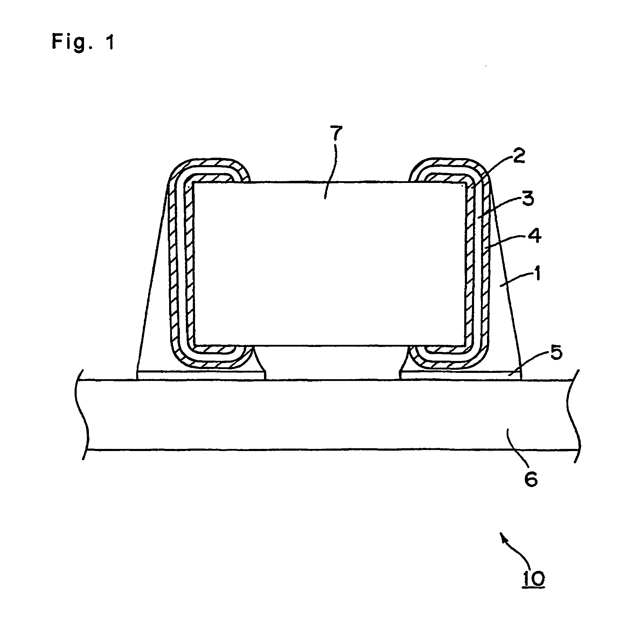

An electronic circuit board in which connections are formed by means of the conventional solder material as described above is exemplarily described below. Fig. 1 schematically shows an enlarged partially cross-sectional view of an electronic circuit board in which a chip component as the electronic component is mounted on the board. Referring to Fig. 1, as to the electronic circuit board 10, the chip component 7 having an underlying electrode 2, an intermediate electrode 3 and an external electrode 4 on its side is mounted on the board (or substrate) 6 by connecting the external electrode 4 and a land 5 by means of a solder material 1. With respect to these elements of the electronic circuit board, for example the underlying electrode 2 is made of Ag, the intermediate electrode 3 is made of Ni, the external electrode 4 and the solder material 1 are made of the Sn-Pb eutectic alloy material, and the land 5 is made of Cu.

The electronic circuit board 10 as shown in Fig. 1 is produced as below. At first, the solder material 1 is applied by means of a screen printing method or the like on the land 5 which has been formed on a predetermined position of the board 6 by etching or the like beforehand. Next, the chip component 7 including the underlying electrode 2, the intermediate electrode 3 and the external electrode 4 on its side which are in the laminar forms is located on the board 6 so as to contact the external electrode 4 with the solder material 1. Then, the board 6 on which the chip component 7 is located is passed through a reflow soldering furnace or the like so as to heat the solder material to the melting point thereof or higher (e.g. 230 °C) and thereby melt the solder material 1, and thereafter it is cooled to the room temperature so as to solidify the solder material. During this process, the molten solder material 1 goes up over a surface of the external electrode 4 due to wetting the external electrode 4 with the solder material 1 and solidifies while keeping such wetting state, for example in the form as shown in Fig. 1. Thus, the chip component 7 (electronic component) is mounted on the board 6.

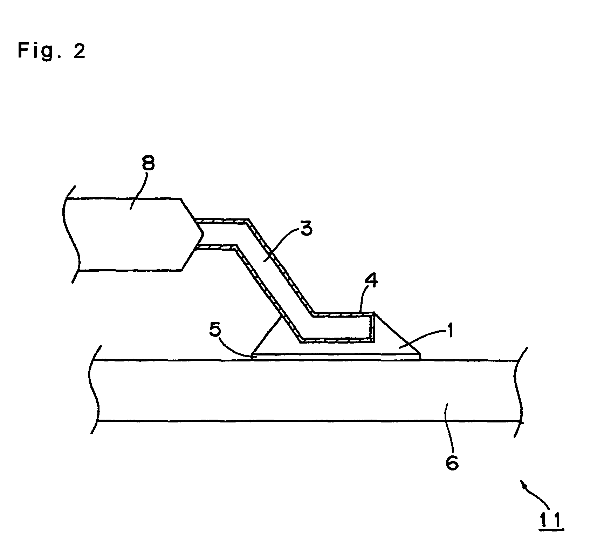

Fig. 2 schematically shows an enlarged partially cross-sectional view of another electronic circuit board in which a leaded component as an electronic component is mounted on the board. Referring to Fig. 2, as to the electronic circuit board 11, the leaded component 8 having an intermediate electrode 3 which comes from its body and an external electrode 4 covering the intermediate electrode 3 is mounted on the board 6 by connecting the external electrode a land 5 by means of a solder material 1. Materials of these elements of the electronic circuit board 11 and a process for mounting the leaded component (electronic component) are similar to those in the case described above with referring to Fig. 1.

As a lead-free solder material in place of the lead containing solder material as described above, using an Sn-Ag based alloy material which contains Sn and Ag as main constituents is proposed. An eutectic composition of an Sn-Ag alloy is Sn-3.5Ag (namely, a composition of 96.5 % by weight of Sn and 3.5 % by weight of Ag on the basis on the whole), and the Sn-Ag alloy has the lowest melting point of 221 °C at the eutectic composition. This lead-free solder material of Sn-3.5Ag has an advantage in the mechanical strength compared with the Sn-Pb eutectic solder material which is conventionally used.

However, the melting point of the Sn-3.5Ag lead-free solder material (i.e. 221 °C) is higher than that of the Sn-Pb eutectic solder material (i.e. 183 °C), so that Sn-3.5Ag solder material has to be heated to a higher temperature in order to melt it compared with the case of the Sn-Pb eutectic solder material. As a result, the board on which the electronic component(s) to be soldered thereto is subjected to a higher temperature during the mounting process of the electronic component in order to reflow (or melt) such Sn-Ag based lead-free solder material. In this case, there is a problem that some electronic component may be damaged since the such higher temperature is above a heat resistant temperature of the electric component.

In addition, the external electrode of the electronic component to be soldered often contains lead, and when the lead-free solder material is used in such case, there arise a problem of a lower connection strength of the electronic component to the board and a lower reliability of the electronic circuit board since a weak (or brittle) alloy (for example, Sn-Bi-Pb alloy) is formed in a connecting portion between the bulk of the solder material and the external electrode (or in the vicinity of the interface between the solder material and the external electrode).

### Disclosure of Invention

The present invention aims to alleviate or at least partially solve the problems as described above and provide an improved lead-free solder material which is preferably used as a connecting material in the mounting process of an electronic component on to a board.

It should be noted that a "solder material" is used to refer to a metal material having a relatively low melting point (for example, 100 to 250 °C), being in a solid state at a normal temperature and used for electrically and physically (or mechanically) connecting electrodes (in other words, for soldering electrodes). In the mounting process of an electronic component, for instance, the solder material is used for electrically and physically connecting an external electrode of the electronic component with a land (or a wiring) formed on a circuit board.

As hitherto known in the field of the physical metallurgy, an eutectic composition of an Sn-Bi alloy is 42Sn-58Bi (namely, a composition of 42 % by weight of Sn and 58 % by weight of Bi on the basis on the whole), and the Sn-Bi alloy has the lowest melting point of about 138 °C at the eutectic composition. This melting point is considerably lower compared with that of the Sn-3.5Ag eutectic alloy (i.e. about 221 °C) as described above. Therefore, in a ternary Sn-Ag-Bi alloy which is resulted by adding Bi to a binary Sn-Ag alloy, a melting point of the Sn-Ag-Bi alloy is lowered as increasing a content of Bi in the Sn-Ag-Bi alloy while maintaining that of Ag at around 3.5 % by weight.

However, the increase of the content of Bi in the Sn-Ag-Bi based alloy not only lowers the melting point thereof but also gives and intensifies brittleness. The alloy material having the brittleness and therefore a poor mechanical strength does not suit for a solder material since it is required to have a high strength for mounting the electronic component.

The present inventors have found that an alloy having a lower melting point while maintaining a high mechanical strength can be realized by adding Ni and In to the Sn-Ag-Bi based alloy as described above. This may be accounted for as follows:

In the case of the Sn-Ag-Bi based alloy having a large content of Bi, a relatively large phase of Bi (or a mass of Bi) is formed upon the solidification of the molten alloy, and the solidified alloy exhibits the brittleness because of such Bi phase which leads to the mechanical strength. On the other hand, in the case of the Sn-Ag-Bi-Ni based alloy resulted from the addition of Ni to the Sn-Ag-Bi based alloy, the formation of the large phase of Bi as described above can be prevented since Bi chemically bonds to Ni upon the solidification of the molten alloy to form a minute compound such as NiBi, NiBi₃ or the like. That is, it is conceived that the addition of Ni converts the Bi phase into the minute and/or separate phase to avoid the decrease of the mechanical strength.

Therefore, there is provided a lead-free solder material of an Sn-Ag-Bi-Ni based alloy according to the present invention, which material has a composition suitably selected for having a melting point and a mechanical strength which are preferable to be used as a solder material, for example for mounting an electronic component(s) onto a board. The composition of the lead-free solder material of the Sn-Ag-Bi-Ni based alloy is preferably selected to have a melting point in the range between 160 °C and 215 °C. A portion of Sn of the lead-free solder material according to the present invention may be replaced with Cu.

The solder material according to the present invention consists of 1.0 to 4.0 % by weight of Ag, 1.0 to 20 % by weight of Bi, 2.5 to 15% by weight of In, 0.1 to 1.0 % by weight of Ni, and the balance of Sn apert from impurities.

Preferred embodiments are as follows:
The solder material further includes 0.1 to 1.0 % by weight of Cu (it is noted that in this embodiment, a portion of Sn is replaced with Cu).
A connection structure has an external electrode which is connected with the solder material according to any one of claims 1 and 2, the external electrode being made of a material of which a main component is selected from a group consisting of Sn, Pd, Sn-Bi, Sn-Cu and Sn-Ag;
A connection portion is made of the solder material according to any one of claims 1 and 2.
An electric/electronic device in which the solder material according to any one of claims 1 and 2 is used for forming a connection.
An electronic circuit board in which an external electrode of an electronic component is connected to a land formed on a board by means of the solder material according to any one of claims 1 and 2; and
A mounting process of an electronic component onto a board, which process comprises connecting an external electrode of the electronic component to a land formed on the board by means of the solder material according to any one of claims 1 and 2.

### Brief Description of Drawings

Fig. 1 schematically shows an enlarged partially cross-sectional view of an electronic circuit board in which a chip component as an electronic component is mounted on a board; and
Fig. 2 schematically shows an enlarged partially cross-sectional view of other electronic circuit board in which a leaded component as an electronic component is mounted on a board.

Following numerals denote the following elements:
1 ... lead containing solder; 2 ... underlying electrode; 3 ... intermediate electrode; 4 ... external electrode; 5 ... land; 6 ... board; 7 ... chip component; 8 ... leaded component; and
10 and 11 ... electronic circuit board.

### Detailed Description of Invention

Hereinafter, the present invention will be described in detail.

In one aspect of the present invention, there is provided a solder material which consists of 1.0 to 4.0 % by weight of Ag, 1.0 to 20 % by weight of Bi, 2.5 to 15% by weight of In, 0.1 to 1.0 % by weight of Ni and the balance of Sn. The solder material may include an unavoidable impurity(ies).

The "% by weight" used herein is based on a total weight of the solder material and a weight of the unavoidable impurity is excluded from the total weight. Therefore, the total number of ratios in "% by weight" of Ag, Bi, In, Ni and Sn theoretically equals to 100.

More particularly, the content of Bi is preferably in the range of about 1.0 to 5.0 % by weight, and more preferably of about 3 % by weight. Additionally, a content of Ni is preferably in the range of about 0.1 to 0.5 % by weight, and more preferably of about 0.3 % by weight.

The unavoidable impurity may include an impurity(ies) which is inherently contained in a raw material for the production of the solder material, an impurity(ies) which is accidentally included during the production of the solder material. The unavoidable impurity may further include an element which is transferred during a soldering process using the solder material of the present invention from a lead of an electronic component into the solder material upon soldering. As the unavoidable impurity, for example, there is an amount of an element such as Pb, Cu and the like which element is unintentionally exists in the solder material. Therefore, it can be understood that the ratios of the composition of the solder material may be changed by the unintentionally added element(s) in some degree.

In this manner, there is provided a solder material which consists of Sn, Ag, Bi, In and Ni of which composition is such that the material has a melting point in the range of 160 to 215 °C, and preferably the range of 160 to 210 °C. The solder material may include the unavoidable impurity(ies) as described above. Such solder material can be resulted by selecting its composition as described above.

According to such solder material of the present invention, there is provided a lead-free solder material having a melting point which is lower than that of the Sn-3.5Ag solder material (221 °C) and which is on a similar level with that of the Sn-Pb eutectic solder material (183 °C) as well as having a sufficient mechanical strength as a solder material. The solder material of the present invention has a sufficient heat resistance or thermal stability (or a thermal fatigue strength) so that it can endure its continuous duty over an extended period. In addition, the solder material of the present invention has a sufficient shock resistance and a specific gravity smaller than that of the Sn-Pb eutectic solder material (and therefore a weight lighter than that of the Sn-Pb eutectic solder material), so that it is preferably used especially for a mobile device and so on. Furthermore, the solder material of the present invention has a good electric conductivity on a similar level with or superior to that of the Sn-Pb eutectic solder material or the Sn-3.5Ag solder material, so that it can be preferably used for a high performance device which carries out a high speed processing.

In one embodiment of the present invention, the solder material of the present invention further contains 0.1 to 1.0 % by weight, and preferably 0.5 to 0.8 % by weight of Cu which replaces a portion of an amount of Sn of the solder material of the present invention. As similarly to the above, the total number of ratios in "% by weight" of Ag, Bi, In, Ni, Cu and Sn theoretically equals to 100. Of course, the solder material may include an unavoidable impurity(ies) as described above.

Containing Cu in a suitable content provides an effect in that the brittleness of the solder material induced by the formation of the relatively large Bi phase is further prevented. If the content of Cu is smaller than 0.1 % by weight, such effect is not obtained sufficiently. If the content of Cu is larger than 1.0 % by weight, the brittleness may be enhanced counter productively. Therefore, the solder material preferably includes Cu in the content described above.

The solder material preferably has a composition consisting of 1.0 to 4.0 % by weight of Ag, 1.0 to 10 % by weight of Bi, 0.1 to 0.5 % by weight of Ni, 1.0 to 10 % by weight of In and the balance of Sn (in other words, 75.5 to 96.9 % by weight of Sn).

Containing In in a suitable content provides an effect in that a melting point of the solder material of the present invention is lowered and also that the brittleness of the material derived from Bi is further prevented by a ductility of In.

Moreover, in the case of the solder material containing In and Cu at the same time, the solder material particularly preferably has a composition consisting of 1.0 to 4.0 % by weight of Ag, 1.0 to 10 % by weight of Bi, 0.1 to 0.5 % by weight of Ni, 1.0 to 10 % by weight of In, 0.5 to 0.7 % by weight of Cu and the balance of Sn (in other words, 74.8 to 96.4 % by weight of Sn).

The solder material of the present invention as described above can be used in any form. For instance, it can be used in the form of a wire solder, a solder for flow (or wave) soldering, a solder ball, a cream solder (or solder paste) or the like. The solder material of the present invention can be used in a mixture with other component(s) such as a flux, an activator, rosin, a thixotropic agent and the like.

The solder material of the present invention is the lead (i.e. Pb) free solder material, and thus an external electrode of the electronic component to be soldered by means of this solder material is preferably made of a lead-free material. In the case in which the solder material and the material for the external electrode are selected so as to contain no lead, no brittle alloy is formed in the connecting portion between a body of the solidified solder material and the external electrode, so that a sufficiently high connection strength and a reliability of the connection can be ensured.

Thus, in other aspect of the present invention, there is provided a connection structure in which the external electrode is connected, for example to a board as an object, with the solder material of the present invention as described above.

Preferably, the external electrode is made of a material which contains Sn, Pd, Sn-Bi, Sn-Cu or Sn-Ag as a main component. The term "main component" means a primary (or dominant) component and the material may be contain any other component(s) at a relatively little amount.

Further in other aspect of the present invention, there is provided a connection portion made of the solder material of the present invention as described above. The connection portion is generally formed by soldering in which the solder material of the present invention is used. Such connection portion may contain other component than the solder material as described above, such as a component(s) eluted from the external electrode (such as a plating material thereof) into the solder material in a molten state. The connection portion may further contain a component(s) which originally exists in other material than the solder material of the present invention and is transferred into the solder material in a molten state upon contacting such other material with the molten solder material to form the connection portion.

The solder material of the present invention is applicable to various electric/electronic devices each of which has a connection structure in which at least an external electrode is connected to a certain object such as a board with the solder material. The term "electric/electronic devices" includes various devices or apparatuses such as household electric appliances, audio/visual systems, and information/communication apparatus. The household electric appliances include, for example, a refrigerator, a washing machine, an air conditioner and so on. The audio/visual systems include, for example, a digital camera, a camcorder, a video tape recorder (or a video tape player), a television set, a digital disc player such as a mini disc player and a compact disc player, a headphone stereo cassette tape recorder and so on, and portable types thereof (e.g. a portable audio) are preferable. Further, the information/communication apparatus include, for example, a personal computer, a mobile phone, an accessory for the personal computer such as a PC card, and a car-navigation system and so on.

Thus, in other aspect of the present invention, there is provided an electric/electronic device (or apparatus) in which the solder material of the present invention as described above is used.

More particularly, there is provided an electronic circuit board in which an external electrode of an electronic component is connected to a land formed on a board by means of the solder material of the present invention as described above.

Further in other aspect of the present invention, there is provided a mounting process of an electronic component, which process comprises connecting an external electrode of the electronic component to a land formed on a board by means of the solder material of the present invention as described above. In other words, there is provided a method for producing the connection structure, the connection portion, the electric or electronic device or the electronic circuit board as described above.

Hereinafter, examples of the present invention as well as comparative examples will be described in detail. It is to be noted that each composition is expressed in a unit of "% by weight" on the basis of the whole weight of the solder material in the Examples and the Comparative Examples.

### (Example 1)

In this example, a solder material was prepared by melting and blending metal materials at a composition ratio as shown in Tables 5 to 16, so that various solder materials were produced. Compositions of solder material within the scope of the present invention are shown in Tables 11 to 16. It is to be noted that a ratio of Sn is not shown in Tables 5 to 16, but the ratio of Sn corresponds to the balance which is resulted by deducting ratios of metal materials (or elements) shown in the Tables except Sn from 100. Further, each composition ratio is shown in a unit of "% by weight" on the basis of the whole as described above, and a blank in the Table shows not containing (i.e. a content of zero).

A melting point (m.p.) (°C) of each of thus prepared solder material was measured as a temperature at which the solder material completely melts by means of a differential thermal analyzer. The measured melting points are also shown in Tables 5 to 16.

Additionally, a tensile strength of each of the solder materials was measured by means of Instron tensile testing machine. The measured values are also shown in Tables 5 to 16. It is noted that composition ratios are shown as to components except for Sn (therefore, the balance consists essentially of Sn). Further, values of the tensile strength are shown in a unit of "kgf/mm²" and together with respectively converted values into a unit of "10⁶ Pa" in a parenthesis.

Furthermore, properties of heat resistance, shock resistance, lightness and electrical conductivity all of which are required to the solder material used for the an electric/electronic device were evaluated using five grades depending on criterions for the evaluation respectively as follows:

### (1) Heat Resistance

Electronic circuit boards were respectively produced by connecting electronic components to circuit boards by means of the various solder materials described above, and thus produced boards were located in an atmosphere at a constant temperature of 125 °C while visually inspected every 500 hours if a crack is observed in a connection portion made of the solder material. Thus, the heat resistance (or thermal fatigue strength) was evaluated as to each of the solder materials according to criterions of Table 1 as below. For instance, if a crack is observed upon an inspection after an elapsed time of 1500 hours in the electronic circuit board though it was not observed upon that of 1000 hours, the solder material used for that board is evaluated as the grade 3. It is preferable the solder material is evaluated as the grade 3 or higher in general in order to be used as the solder material which can endure a continuous duty over a long duration, though it is not essential since a requirement for reliability differs depending on each electric circuit board.

**Table 1**

| Criterion for Evaluation of Heat Resistance | | |
|---|---|---|
| Elapsed Time (hours) | Visual Inspection | Evaluation Grade |
| 2000 | no crack | 5 |
| 1500 | no crack | 4 |
| 1000 | no crack | 3 |
| 500 | no crack | 2 |
| 500 | with crack | 1 |

### (2) Shock Resistance

Electronic circuit boards were respectively produced by connecting electronic components to circuit boards by means of the various solder materials described above, and thus produced boards were subjected to a drop impact test with a height of 0.1 m and then tested for their electric functions by evaluating whether if the electronic components function normally (which test is also referred to as the functioning test). Thereafter, as to the electric circuit boards each having a good result in the functioning test, surfaces of their connection portions made of the solder material were visually inspected. Thus, the shock resistance f the solder material was evaluated as to each of the boards according to criterions of Table 2 as below. For instance, if an electronic circuit board is found to have a defect through the test of the electric function, the solder material used for that board is evaluated as the grade 1. If an electronic circuit board is good according to the test of the electric function but a fine crack is observed in the solder material portion, the solder material used for that board is evaluated as the grade 3. It is preferable that the solder material is evaluated as the grade 3 or higher in general in order to be used for soldering, though it is not essential. It is more preferable that the solder material is evaluated as the grade 5 in order to be used especially in a device such as a potable device requiring a high shock resistance. It is noted that the term "wrinkle" as used in Table 2 means a wrinkling phenomenon on a surface of the solidified solder material which phenomenon is observed just before growth into the crack from the wrinkle.

**Table 2**

| Criterion for Evaluation of Shock Resistance | | |
|---|---|---|
| Functioning Test | Visual Inspection | Evaluation Grade |
| good | no crack | 5 |
| good | with wrinkle | 4 |
| good | with small crack | 3 |
| good | with crack | 2 |
| defective | - | 1 |

### (3) Lightness

A specific gravity "dₙ" of each of the various solder materials described above was measured and the lightness in weight thereof was evaluated according to criterions of Table 3 as below by comparing thus measured specific gravity with that of the conventional Sn-Pb eutectic solder material "d₀". It is preferable the solder material is evaluated as the grade 4 or higher in order to attain the lightness which is at least similar to that of the conventional Sn-Pb eutectic solder material, though it is not essential. It is noted d₀ is 8.3 g/cm³.

**Table 3**

| Criterion for Evaluation of Lightness | |
|---|---|
| Specific Gravity | Evaluation Grade |
| dₙ ≤ d₀ x 0.9 | 5 |
| d₀ x 0.9 < dₙ ≤ d₀ | 4 |
| d₀ < dₙ ≤ d₀ x 1.5 | 3 |
| d₀ x 1.5 < dₙ ≤ d₀ x 2.0 | 2 |
| d₀ x 2.0 < dₙ | 1 |

### (4) Electric Conductivity

An electric resistance "Rₙ" of each of the various solder materials described above was measured and the electric conductivity thereof was evaluated according to criterions of Table 4 as below by comparing thus measured electric resistance with that of the conventional Sn-Pb eutectic solder material "R₀". It is preferable the solder material is evaluated as the grade 5 in order to attain the electric conductivity which is at least similar to that of the conventional Sn-Pb eutectic solder material, though it is not essential. It is noted that R₀ is 0.2 µΩ·m.

**Table 4**

| Criterion for Evaluation of Electric Conductivity | |
|---|---|
| Electric Resistance | Evaluation Grade |
| Rₙ ≤ R₀ | 5 |
| R₀ < Rₙ ≤ R₀ x 1.3 | 4 |
| R₀ x 1.3 < Rₙ ≤ R₀ x 1.5 | 3 |
| R₀ x 1.5 < Rₙ ≤ R₀ x 2.0 | 2 |
| R₀ x 2.0 < Rₙ | 1 |

Thus evaluated results are also shown in Tables 5 to 16 below regarding to the properties of (1) the heat resistance, (2) the shock resistance, (3) the lightness and (4) the electric conductivity of the various solder material respectively based on the criterions for evaluation as described above.

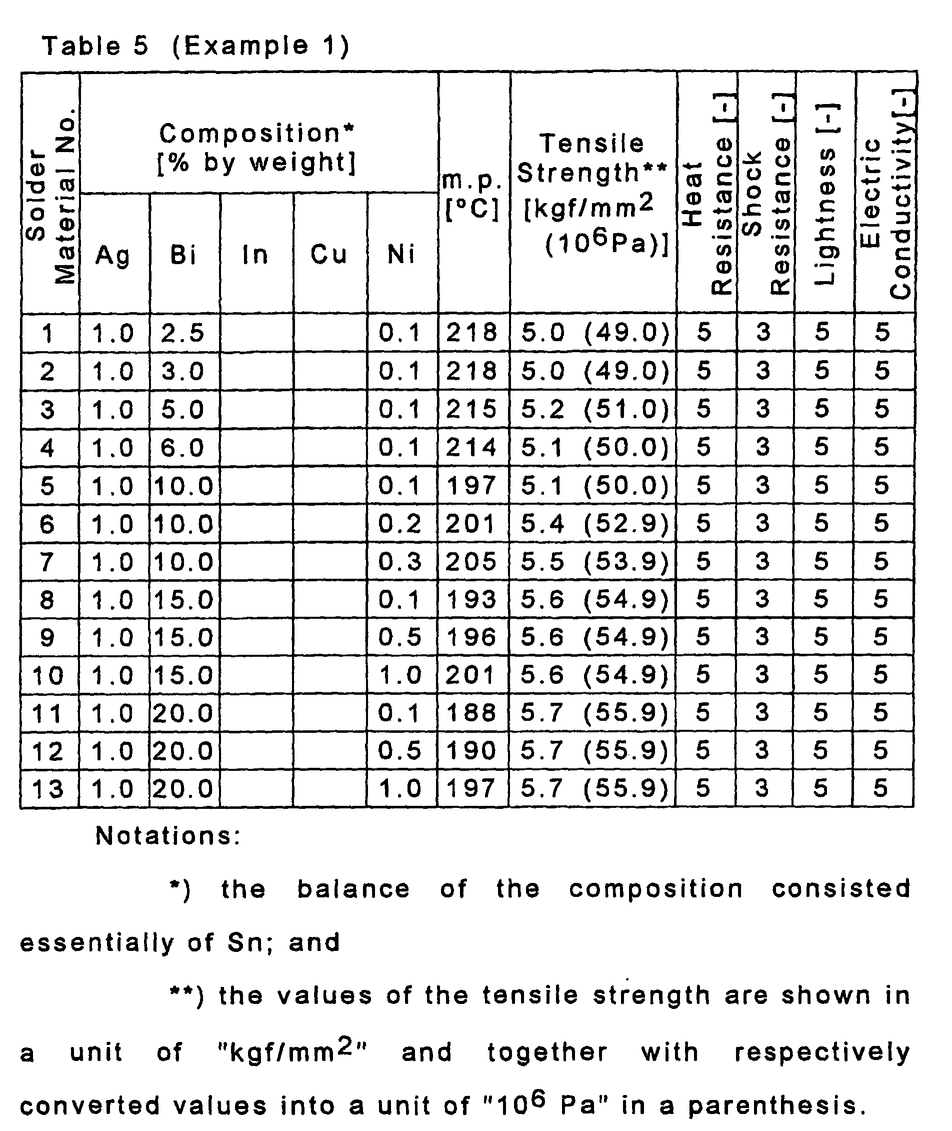

These notations are not described with Tables 6 to 16 but they are also applicable to Tables 6 to 16.

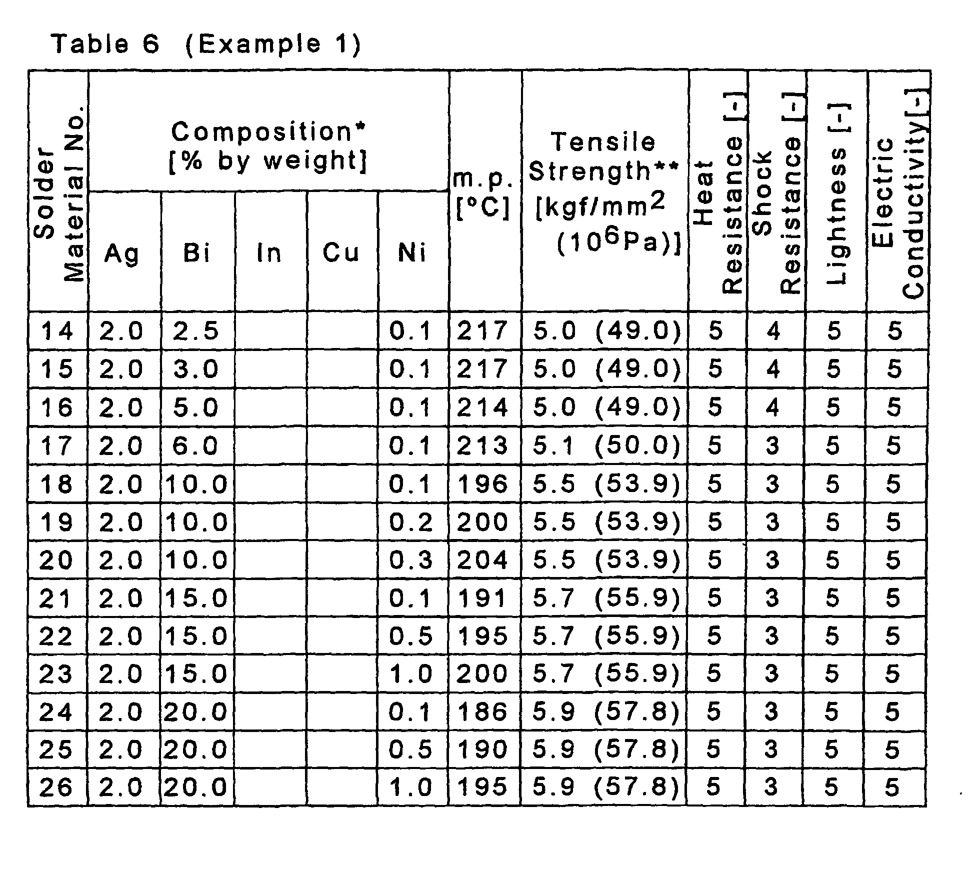

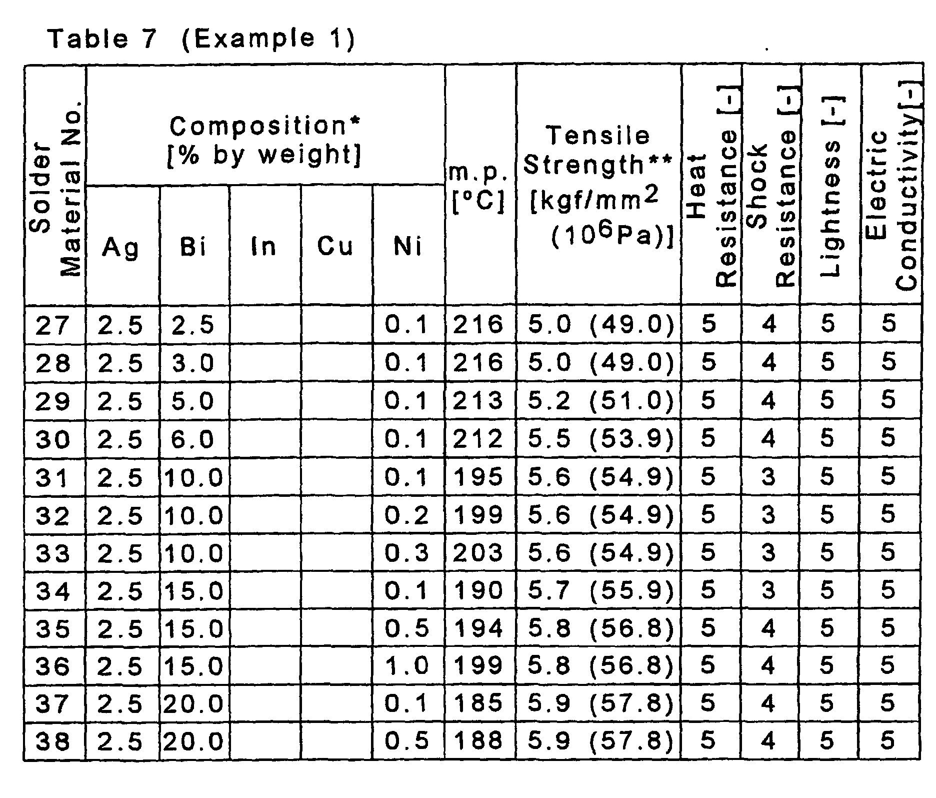

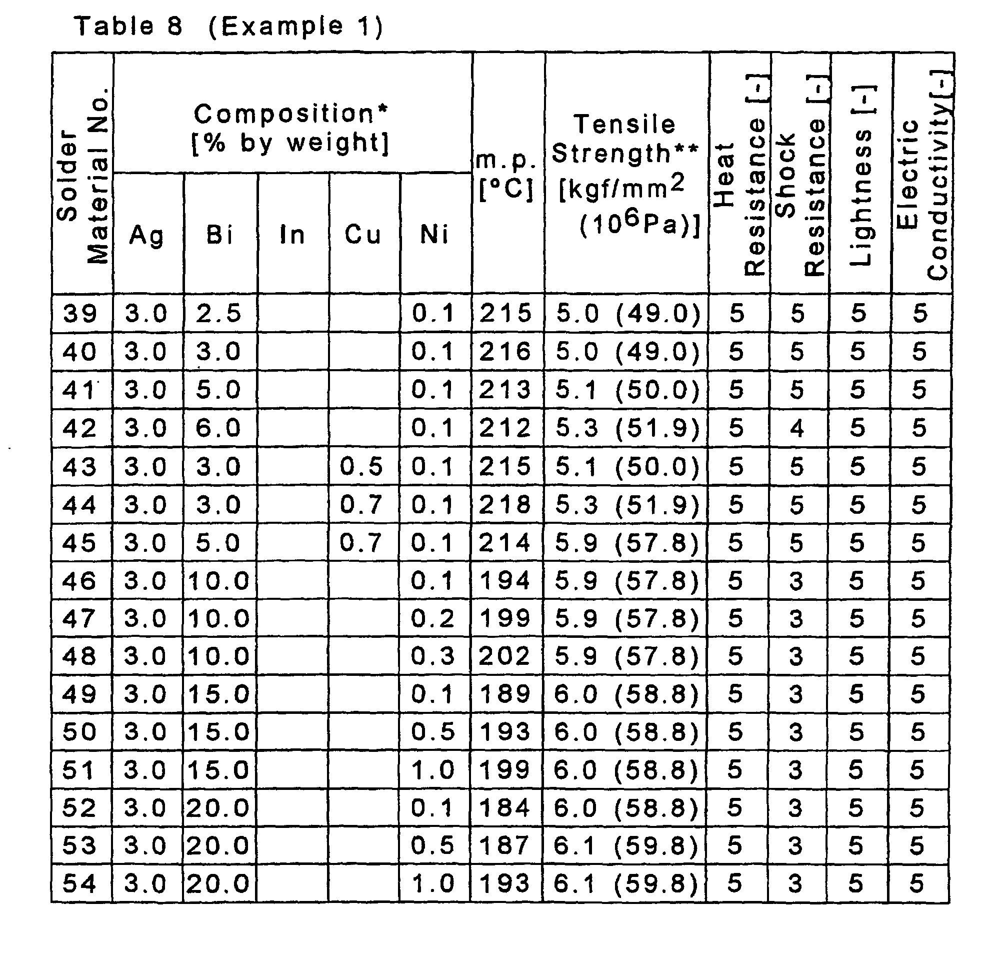

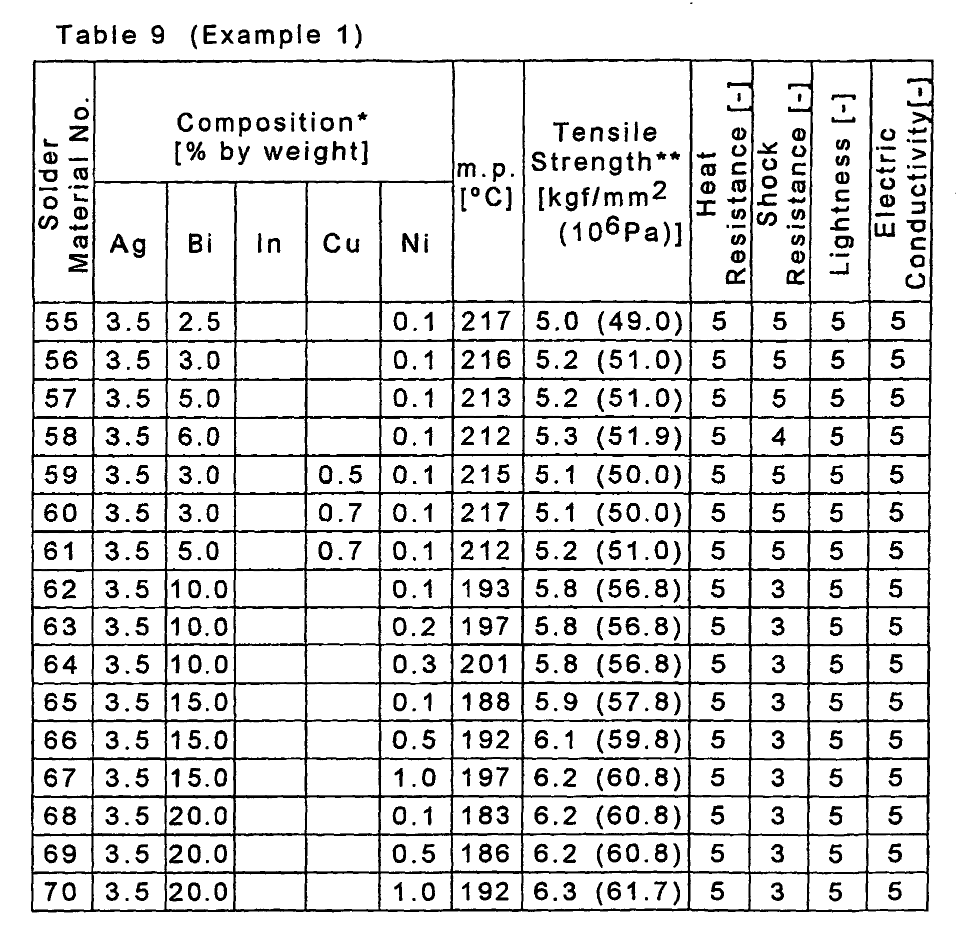

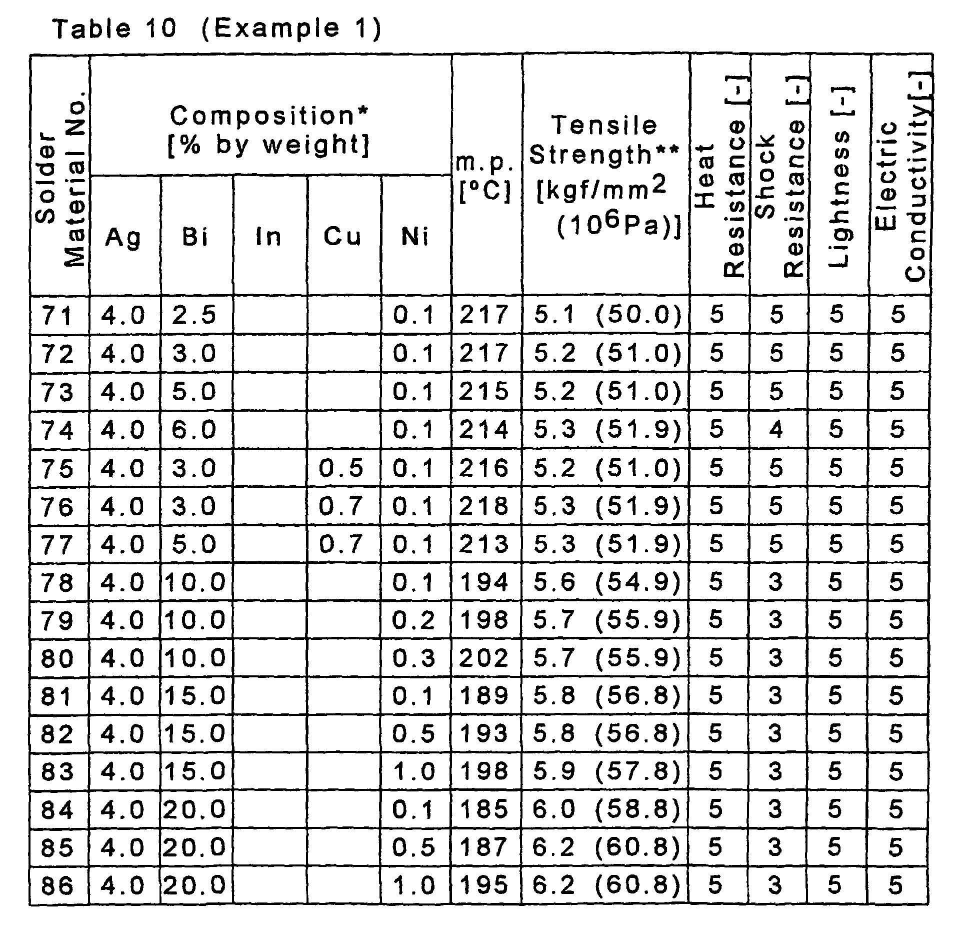

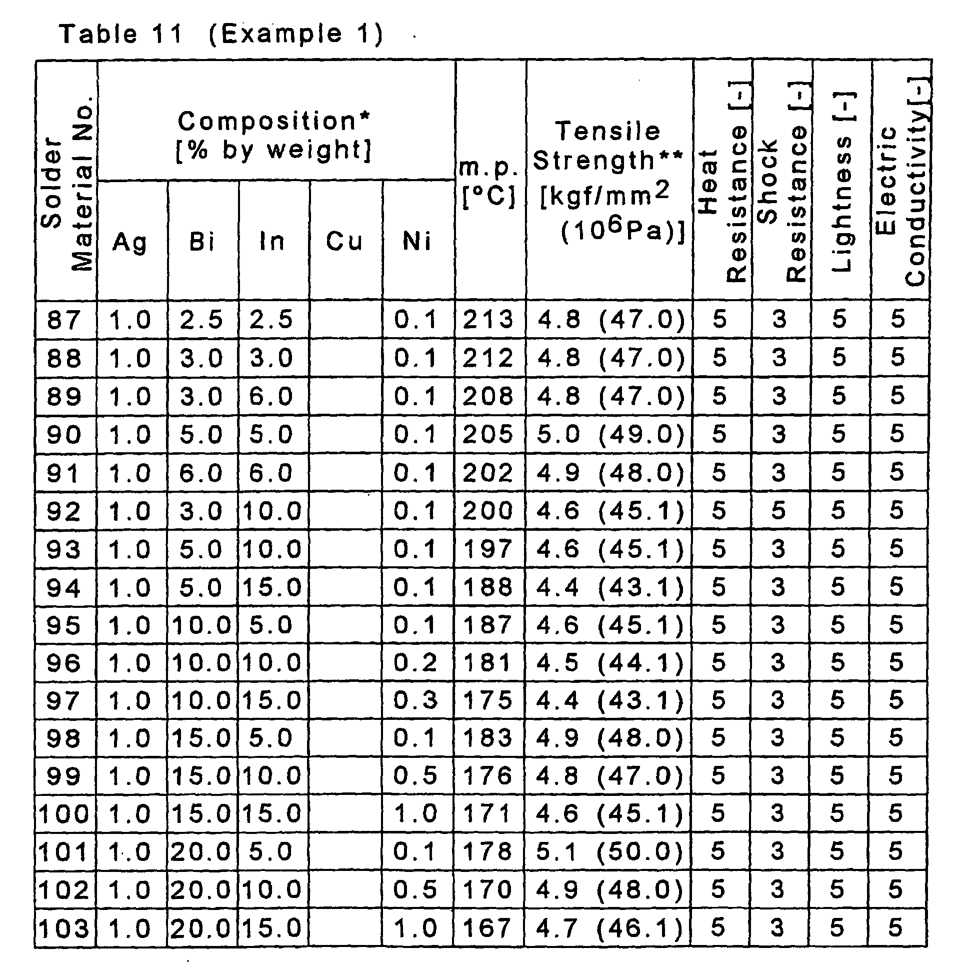

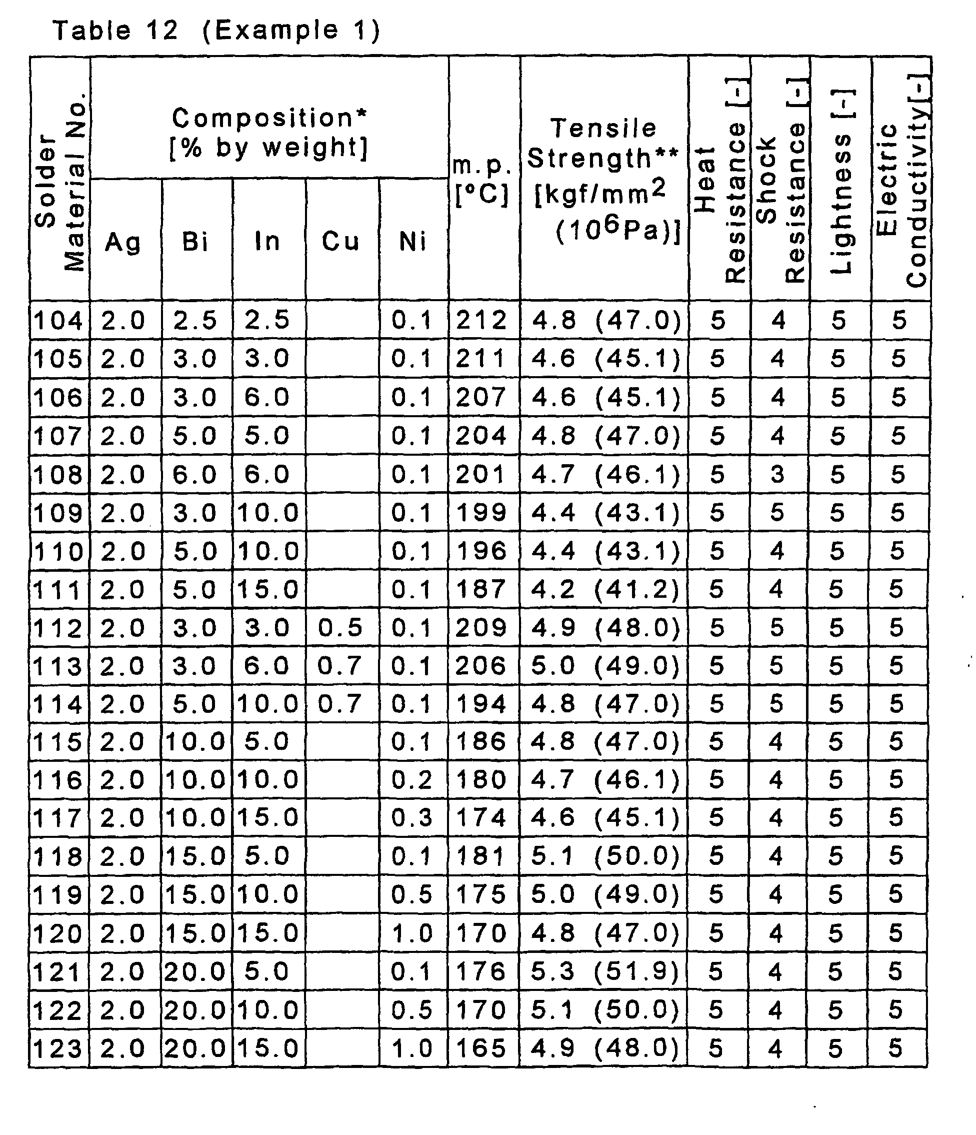

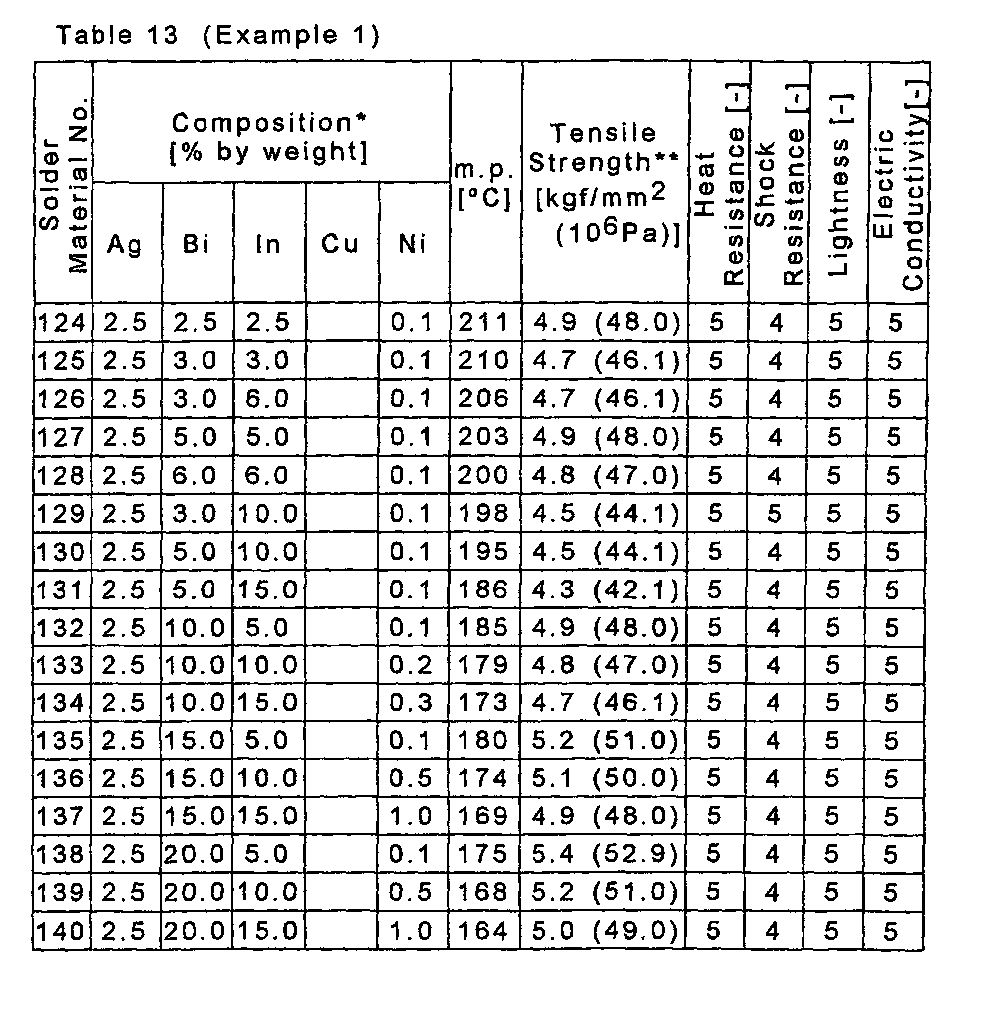

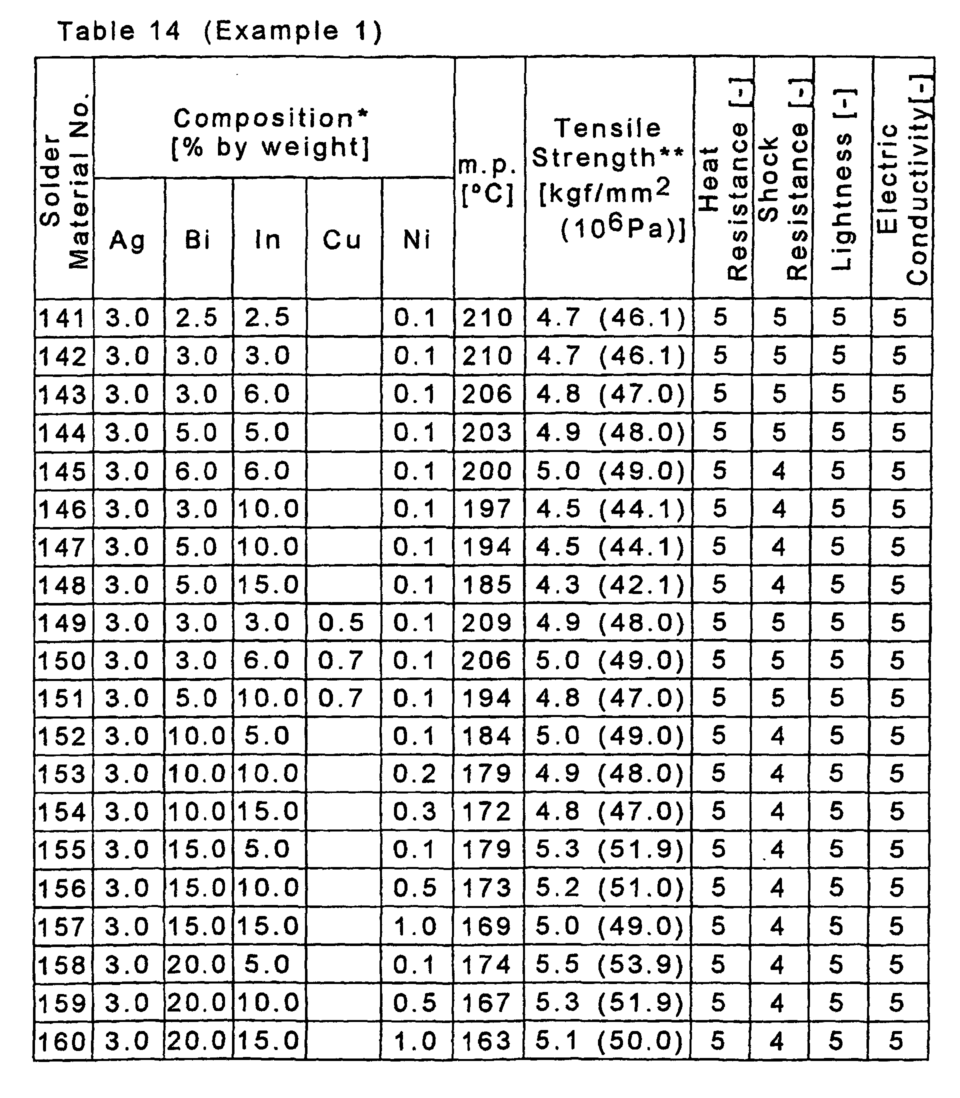

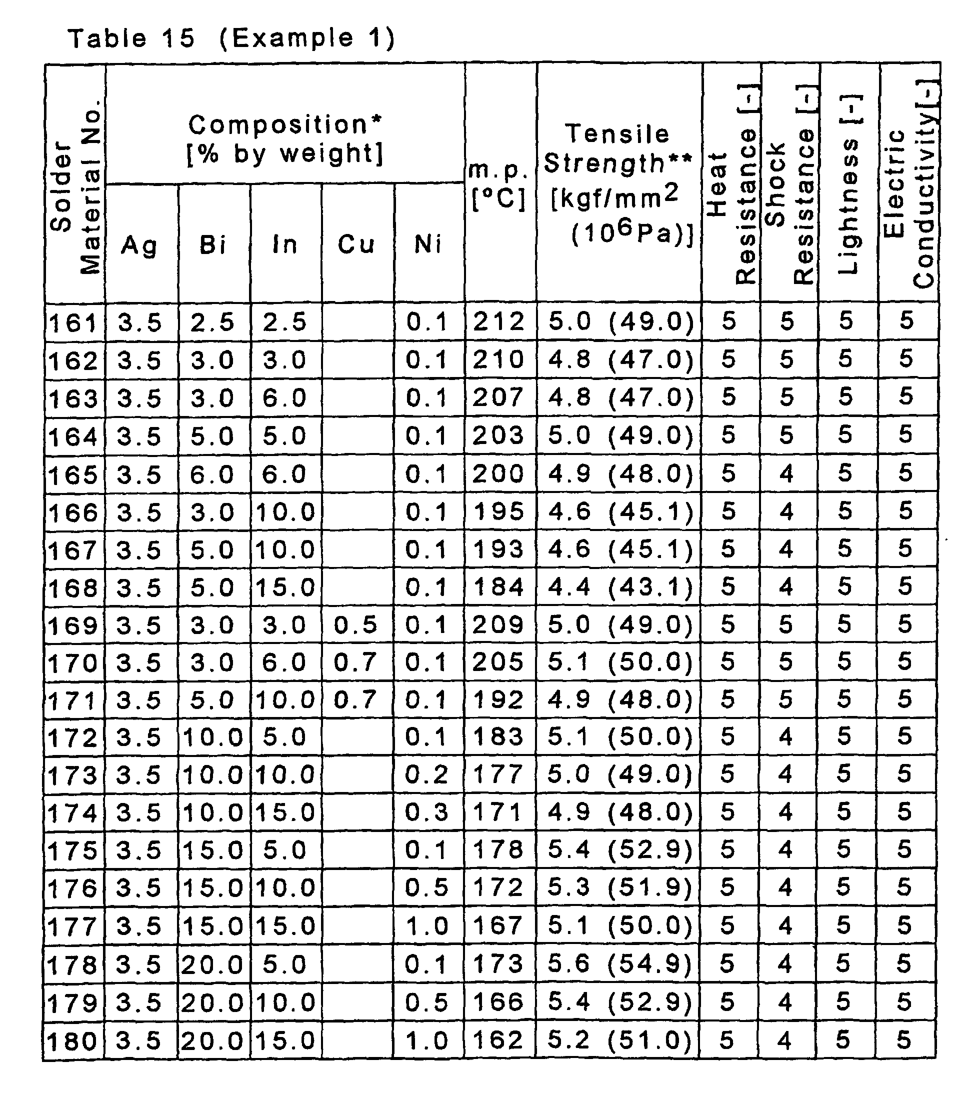

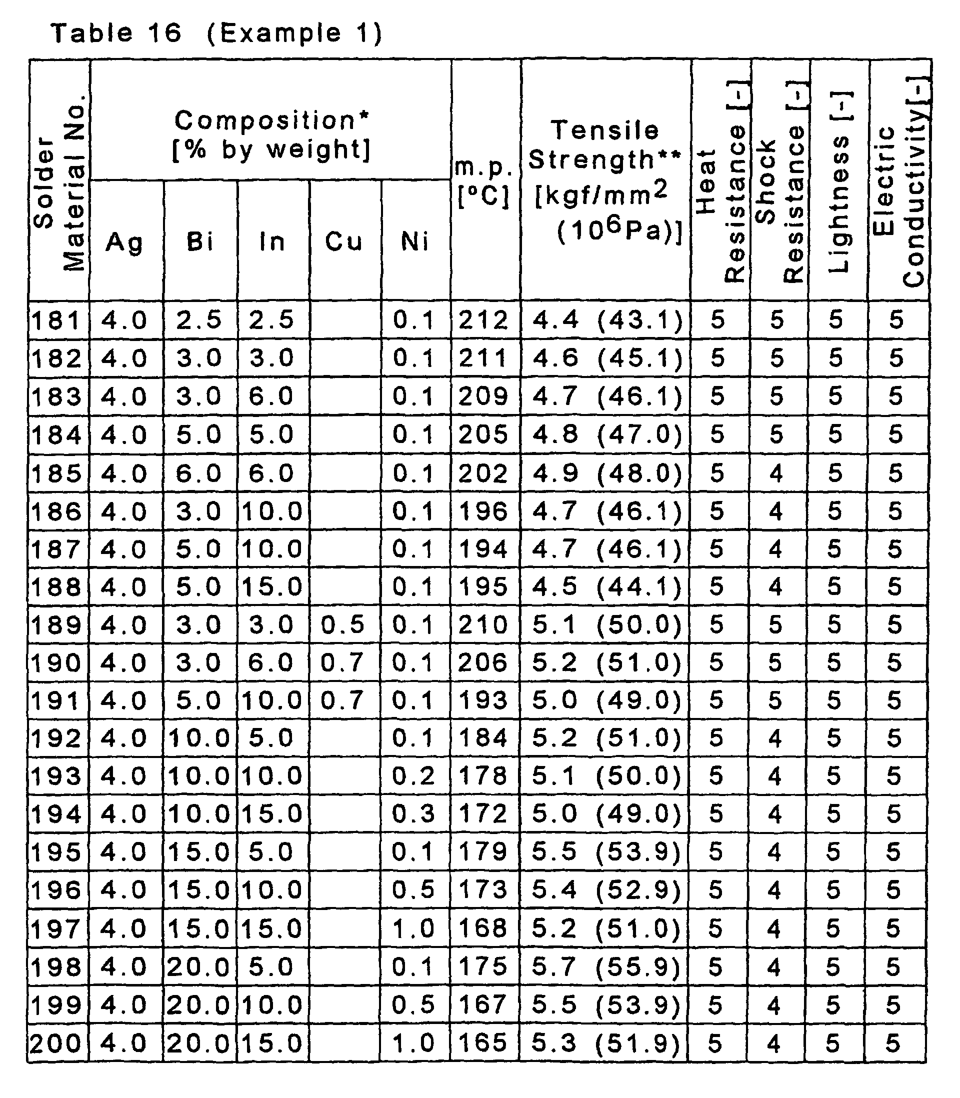

### (Comparative Example 1)

Additionally, as a comparative example with respect to Example 1, the conventional Sn-Pb eutectic solder material (i.e. 63Sn-37Pb alloy material) and the Sn-3.5Ag eutectic solder material (i.e. 96.5Sn-3.5Ag alloy material) as well as materials each of which was prepared by adding In, Cu and/or Ni to an Sn-Ag-Bi based solder material to have a certain composition outside the scope of the present invention were evaluated as similarly to Example 1. Results are shown in Tables 17 and 18. It is noted that values and grades are shown in the same manners as those of Tables 5 to 16.

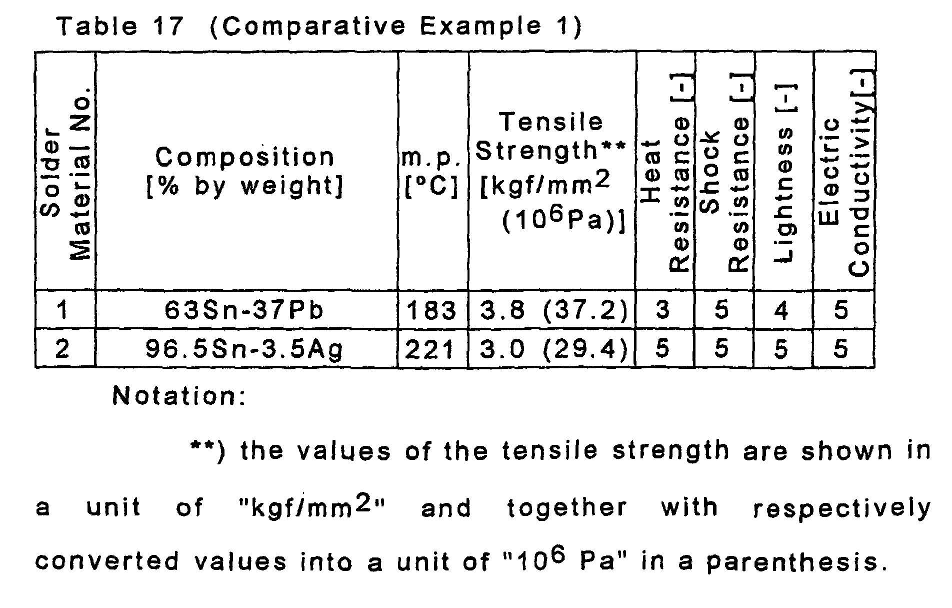

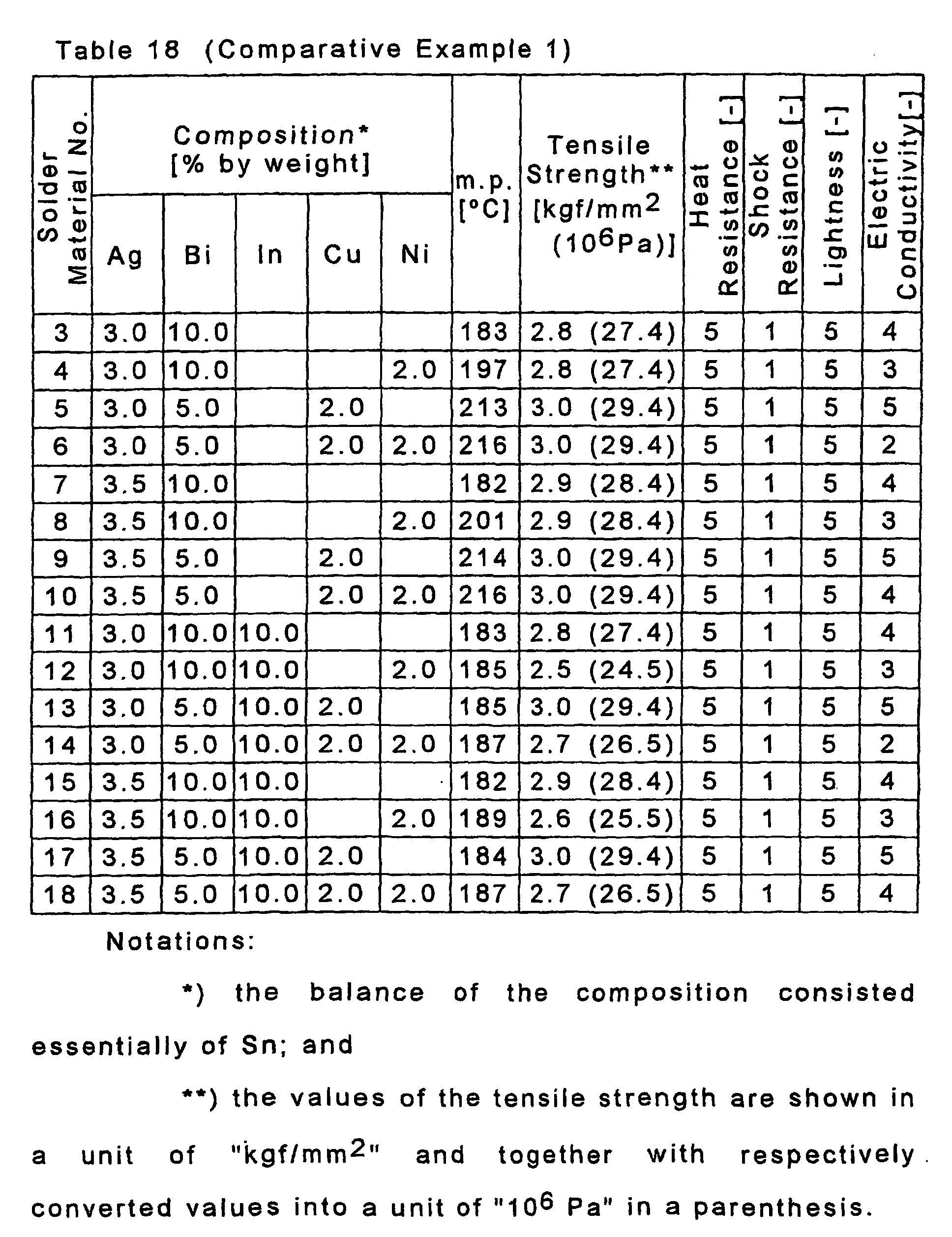

The melting points of the solder materials of Example 1 shown in Tables 5 to 16 were in the range from 162 to 218 °C, lower than that of 221 °C of the Sn-3.5Ag solder material shown in Table 17 (No. 2 of Comparative Example 1), and at a similar level to that of 183 °C of the Sn-Pb eutectic solder material also shown in Table 17 (No. 1 of Comparative Example 1).

With respect to a mechanical strength, it can be evaluated based on the tensile strength described above as a measure. The solder materials of Example 1 had the tensile strength in the range from 4.2 to 6.3 kgf/mm² (from 41.2 x 10⁶ to 61.7 x 10⁶ Pa) with referring to Tables 5 to 16. Such values of the tensile strength were sufficiently higher than those of 3.8 kgf/mm² (37.2 x 10⁶ Pa) of the Sn-Pb eutectic solder material (No. 1 of Comparative Example 1) and of 3.0 kgf/mm² (29.4 x 10⁶ Pa) of the Sn-3.5Ag solder material (No. 2 of Comparative Example 1) shown in Table 17. Further, such values were also higher than those in the range from 2.5 to 3.0 kgf/mm² (from 24.5 x 10⁶ to 29.4 x 10⁶ Pa) of the Sn-Ag-Bi based solder materials of which compositions are outside the scope of the present invention (Nos. 3 to 18 of Comparative Example 1). Therefore, the solder materials of Example 1 had a sufficiently high mechanical strength, and it can be understood that the mechanical strength of the Sn-Ag-Bi based solder material can be increased by selecting its composition within the scope of the present invention.

In addition, with referring to Tables 5 to 16, the heat resistance of all the solder materials of Example 1 were evaluated as the grade 5. Thus, the solder materials of Example 1 had enough thermal fatigue strength and considered to be able to endure a continuous duty over a long duration.

Also referring to Tables 5 to 16, the shock resistance of the solder materials of Example 1 were on the similar level to those of the Sn-Pb eutectic solder material and the Sn-3.5Ag solder material shown in Table 17 (Nos. 1 and 2 of Comparative Example 1 respectively) and higher than that of the Sn-Ag-Bi based solder material having a composition outside the scope of the present invention (Nos. 3 to 18 of Comparative Example 1). Therefore, the solder materials of Example 1 had a sufficiently high shock resistance, and it can be understood that the shock resistance of the Sn-Ag-Bi based solder material can be enhanced by selecting its composition within the scope of the present invention.

The solder materials of Example 1 had the specific gravity lower than that of the Sn-Pb eutectic solder material and were evaluated as the grade 5 as to the lightness in weight as shown in Tables 5 to 16. Thus, the solder materials of Example 1 can be preferably used in an apparatus of which lightness is in particular regarded such as a portable equipment.

Furthermore, the solder materials of Example 1 were evaluated as the grade 5 as to its electric conductivity as shown in Tables 5 to 16, and had a conductivity similar to those of the Sn-Pb eutectic solder material and the Sn-3.5Ag solder martial shown in Table 17 (Nos. 1 and 2 of Comparative Example 1 respectively) and higher than those of the Sn-Ag-Bi based solder materials each having a composition outside the scope of the present invention (Nos. 3 to 18 of Comparative Example 1). Therefore, similarly to the conventional Sn-Pb eutectic solder material, the solder materials of Example 1 can be preferably used in an apparatus which processes at a high speed.

It is understood from those results described above that the solder material of the present invention is lighter in weight than the Sn-Pb eutectic solder material, and has a lower melting point than the Sn-3.5Ag solder material as well as a sufficiently high mechanical strength, heat resistance, shock resistance and electric conductivity.

### Industrial Applicability

According to the solder material of the present invention, there can be provided a lead-free solder material having a sufficient mechanical strength as well as a melting point which is lower than that of the Sn-3.5Ag solder material and which is similar to the melting point of the Sn-Pb eutectic solder material. The solder material of the present invention has a sufficient heat resistance (or thermal fatigue resistant strength) so that it can endure under continuous duty over a long duration. In addition, the solder material of the present invention has a sufficient shock resistance and a lighter weight because of its smaller specific gravity than that of the Sn-Pb eutectic solder material, so that it is preferably used especially for a portable equipment and so on. Furthermore, the solder material of the present invention has a good electric conductivity which is similar or superior to those of the Sn-Pb eutectic solder material and the Sn-3.5Ag solder material, so that it can be preferably used for a high performance device which processes at a high speed.

Additionally, there also can be provided a connection structure and/or a connection portion having a sufficient connection strength by using the solder material of the present invention. The solder material of the present invention is preferably used as a solder material for mounting an electronic component onto a board in a manufacturing process of an electronic circuit board in particular, though it can be applied to various electronic or electric devises.

The present application claims a priority under the Paris Convention to Japanese Patent Application No. 2000-281718 filed on September 18, 2000, entitled "SOLDER MATERIAL AND ELECTRIC/ELECTRONIC DEVICE IN WHICH THE SAME IS USED".

## Claims

1. A solder material consisting - apart from impurities - of 1.0 to 4.0% by weight of Ag, 1.0 to 20% by weight of Bi, 2.5 to 15% by weight of In, 0.1 to 1.0% by weight of Ni, and the balance of Sn.

2. The solder material according to claim 1, further including 0.1 to 1.0% by weight of Cu in place of a portion of Sn.

3. A connection structure in which an external electrode is connected with the solder material according to any one of claims 1 and 2, and the external electrode is made of a material of which main component is selected from the group consisting of Sn, Pd, Sn-Bi, Sn-Cu and Sn-Ag.

4. A connection portion made of the solder material according to any one of claims 1 and 2.

5. An electric or electronic device in which the solder material according to any one of claims 1 and 2 is used for forming a connection.

6. An electronic circuit board in which an external electrode of an electronic component is connected to a land formed on a board by means of the solder material according to any one of claims 1 and 2.

7. A process for mounting an electronic component, which process comprises connecting an external electrode of the electronic component to a land formed on a board by means of the solder material according to any one of claims 1 and 2

## Patentansprüche

1. Lötmaterial, bestehend - abgesehen von Unreinheiten - aus Gewichtsanteilen von 1,0 bis 4,0 % Silber (Ag), 1,0 bis 20 % Bismut (Bi), 2,5 bis 15 % Indium (In), 0,1 bis 1,0 % Nickel (Ni) und zum restlichen Teil aus Zinn (Sn).

2. Lötmaterial gemäß Anspruch 1, ferner beinhaltend 0,1 bis 1,0 Gew.-% Cu an Stelle eines Anteils Sn.

3. Verbindungsstruktur, bei der eine externe Elektrode mit dem Lötmaterial gemäß einem der Ansprüche 1 bis 2 verbunden ist, wobei die externe Elektrode aus einem Material hergestellt ist, dessen Hauptkomponente aus der Gruppe bestehend aus Sn, Pd, Sn-Bi, Sn-Cu und Sn-Ag ausgewählt ist.

4. Verbindungsteil, hergestellt aus dem Lötmaterial gemäß einem der Ansprüche 1 und 2.

5. Elektrisches oder elektronisches Gerät, bei dem das Lötmaterial gemäß einem der Ansprüche 1 und 2 zum Bilden einer Verbindung verwendet ist.

6. Elektronikplatine, bei der eine externe Elektrode einer elektronischen Komponente mit einem auf einer Platine gebildeten Lötauge mittels Lötmaterial gemäß einem der Ansprüche 1 oder 2 verbunden ist.

7. Verfahren zum Befestigen einer elektronischen Komponente, wobei das Verfahren das Verbinden einer externen Elektrode der elektronischen Komponente mit einem auf einer Platine geformten Lötauge mittels Lötmaterial gemäß einem der Ansprüche 1 oder 2 umfasst.

## Revendications

1. Matériau de brasage constitué, hormis des impuretés, de 1,0 à 4,0 % en poids d'Ag, de 1,0 à 20 % en poids de Bi, de 2,5 à 15 % en poids d'In, de 0,1 à 1,0 % en poids de Ni et le complément de Sn.

2. Matériau de brasage selon la revendication 1, comprenant en outre 0,1 à 1,0 % en poids de Cu à la place d'une partie du Sn.

3. Structure de connexion dans laquelle une électrode extérieure est reliée au matériau de brasage selon l'une quelconque des revendications 1 et 2, et l'électrode extérieure est constituée d'un matériau dont le composant principal est choisi dans le groupe constitué par Sn, Pd, Sn-Bi, Sn-Cu et Sn-Ag.

4. Partie de connexion constituée du matériau de brasage selon l'une quelconque des revendications 1 et 2.

5. Dispositif électrique ou électronique dans lequel le matériau de brasage selon l'une quelconque des revendications 1 et 2 est utilisé pour former une connexion.

6. Plaquette à circuit électronique dans laquelle une électrode extérieure d'un composant électronique est reliée à une pastille formée sur une plaquette au moyen du matériau de brasage selon l'une quelconque des revendications 1 et 2.

7. Procédé de montage d'un composant électronique, procédé qui comprend la connexion d'une électrode extérieure du composant électronique sur une pastille formée sur une plaquette au moyen du matériau de brasage selon l'une quelconque des revendications 1 et 2.
